Europäisches Patentamt

European Patent Office

Office européen des brevets

(19)

(11) Publication number: **0 009 617**
**B1**

(12) **EUROPEAN PATENT SPECIFICATION**

(45) Date of publication of patent specification: **14.03.84**

(21) Application number: **79103177.6**

(22) Date of filing: **28.08.79**

(51) Int. Cl.³: **H 03 J 5/00, H 04 B 1/26, H 03 J 1/04**

(54) Circuit for controlling a receiving frequency and a channel display in a superheterodyne receiver.

(30) Priority: **28.08.78 JP 105795/78**
**31.08.78 JP 120756/78**

(43) Date of publication of application:
**16.04.80 Bulletin 80/8**

(45) Publication of the grant of the patent:
**14.03.84 Bulletin 84/11**

(84) Designated Contracting States:
**DE FR GB**

(56) References cited:
DE - A - 2 362 853
DE - A - 2 645 833
DE - A - 2 648 882
GB - A - 2 002 190
US - A - 4 024 476
US - A - 4 048 570
US - A - 4 088 959

FUNK-TECHNIK, 33. Jahrgang, Nr. 15/1978,
München und Heidelberg, W. Clas
"Sendereinstellung durch Tastenwahl der
Fernsehkanäle", pages F&E 137-153
FUNK-TECHNIK, 32. Jahrgang, Nr. 22/1977,
München und Heidelberg, Dr. Ing. G. Dickopp
"Microprozessor als Abstimmhilfe", pages F&E
391, 392

(73) Proprietor: **SANYO ELECTRIC CO., LTD.**
**18, Keihanhondori 2-chome**
**Moriguchi-shi Osaka-fu (JP)**

(73) Proprietor: **Tottori Sanyo Electric Co., Ltd.**
**201 Yoshikata Tottori-shi**
**Tottori 680 (JP)**

(72) Inventor: **Sumi, Yasuaki**
**128, Mihagino 1-chome**
**Tottori-shi Tottori-ken (JP)**

(74) Representative: **Glawe, Delfs, Moll & Partner**
**Patentanwälte**
**Postfach 26 01 62 Liebherrstrasse 20**
**D-8000 München 26 (DE)**

(56) References cited:
FUNKSCHAU, 48. Jahrgang, Nr. 8/1976,
München, K. Holetzek et al. "Ein HI-FI-Spitzen-
Receiver mit digitalen Anzeigen", pages 286 to
290
FUNKSCHAU, 48. Jahrgang, Nr. 9/1976,
München, O. Klank, D. Rottmann "Digitale
Frequenz-Kanal- und Zeitanzeige in einem
Spitzen-Receiver", pages 334 to 337

Courier Press, Leamington Spa, England.

## Circuit for controlling a receiving frequency and a channel display in a superheterodyne receiver

The invention relates to a superheterodyne receiver to be tuned by selecting a desired tuning channel identified by a channel number, comprising a manual channel selection input connected to channel number processing means for forming channel number data representing the number of a selected channel; channel number display means responsive to said channel number data for displaying the selected channel number and control means responsive to data converted from said channel number data for controlling the frequency of a local oscillator included in the tuning circuit of the receiver said channel number processing means comprising fixed number presetting means for presetting a fixed number and operation means for forming said channel number data by mathematical operation from said preset fixed number and a numerical value associated with said channel number set by numerical value setting means.

A receiver of this type has been known from US-patent 4 024 476. It has the advantage that it facilitated the selection of a desired broadcasting station in that signal channel numbers can be inputted, and will be digitally displayed, which are easier to memorize than the exact frequency values of the various broadcasting stations. Also, the station display is controlled directly from the inputted and processed channel number data and does not require control signals obtained from the actual oscillation frequency of the local oscillator through counting means, frequency dividing means etc.

In certain environments particularly in Europe, a broadcasting standard is employed where one respective channel number identifies a plurality, usually three, independent channels having different frequencies. This has arisen historically by increasing the number of broadcasting frequencies, in a given frequency band, from 56 to 168, whilst at the same time reducing the spacing between adjacent broadcasting frequencies from 300 kHz to 100 kHz, without at the same time changing the channel numbers. Accordingly, there are now three independent channels with different frequencies grouped under the same channel numbers, and they are distinguished from each other with an additional channel index. For example, the broadcasting frequency of 93,3 MHz is identified as channel No. 21 or channel No. 21° in the above described channel indication, wherein the notation "0" indicates that the broadcasting frequency of 93,3 MHz is a broadcasting frequency allotted before 1962. On the other hand, the frequency of 93,2 MHz is identified as channel No. 21$^-$, wherein the notation "−" indicates that the channel of the frequency 93,2 MHz was allotted after 1962 and is of the frequency 100 kHz lower than that of the channel of the same channel number allotted before 1962. The frequency of 93,4 MHz is identified as channel No. 21$^+$, wherein the notation "+" indicates that the channel was allotted after 1962 and is of the frequency 100 kHz higher than the frequency of the channel of the same channel number allotted before 1962. Therefore, according to the channel number indication with the additional channel indexes, a digital indication of the channel number need be followed by an additional indication of the channel indexes such as "−" and "+".

The receiver disclosed in US-patent 4 024 476 is not particularly adapted to such an environment. Also it lacks the possibility of checking the correct tuning to a desired station by displaying the corresponding receiving frequency.

Receivers having the possibility of displaying both channel number and receiving frequency have been known from Funkshau No. 8, 1976, pages 286—290 and Funkshau No. 9, 1976, pages 334—337.

It is an object of the present invention to provide a receiver of the above mentioned kind which enables with eyes to select and display respective individual channels, as well as the corresponding frequency, in a system where a plurality of adjacent channels having different frequencies are grouped under one common channel number.

For solving this object the invention provides a receiver of the aforementioned kind which is characterized in that for use in an environment wherein in a given frequency band a series of channel numbers is allotted such that one channel number stands for a plurality of independent channels grouped under said one channel number the receiver further comprises frequency display means responsive to frequency data converted from said channel number data by frequency data converting means which include multiplication means for multiplying said channel number data by a factor commensurate with said plurality, first addition means for adding data associated with the frequency of a channel at one extremity of said frequency band to the product obtained by said multiplication means, and second addition means for adding to the sum of said first addition means the count value of counting means included in said channel number processing means, said counting means being provided for counting the number of channel number setting pulses supplied in response to the manual operation of the manual channel selection input.

By providing in the set channel number processing means a counter which counts channel number setting pulses generated in response to the manual operation of the channel number selecting input, a count value is obtained which is suitable not only for controlling the display of the channel number index distinguishing the different channels grouped under one channel number, but which can also be incorporated in a very simple manner in the frequency data converting means for obtaining the frequency data identifying this particular channel within the channel group identified by the set channel number data. Furthermore, in displaying the receiving frequency in a digital manner, both the channel number and the receiving frequency can be displayed switchably and selectively by means of a common display. In displaying both the channel number and the receiving frequency by the use of a common display as described previously, a decimal point indicating means for use in indication of the receiving frequency and a channel index indicating means for use in indicating the channel number can be commonly connected to the same line, for being alternatively controlled. As a result, an additional display control required for the channel index indicating means can be simply performed.

Fig. 1 is a block diagram showing one embodiment of the present invention;

Fig. 1A is a block diagram showing another embodiment of the present invention, wherein the control circuit 300 is implemented by a microcomputer;

Fig. 2 is a flow diagram for explaining the operation of the present invention;

Fig. 3 is a schematic diagram showing in more detail the major portion of another embodiment of the present invention;

Fig. 4 is a graph showing waveforms of timing signals in case of the Fig. 3 embodiment; and

Fig. 5 is a graph showing waveforms of various signals for explaining the operation of the Fig. 3 embodiment.

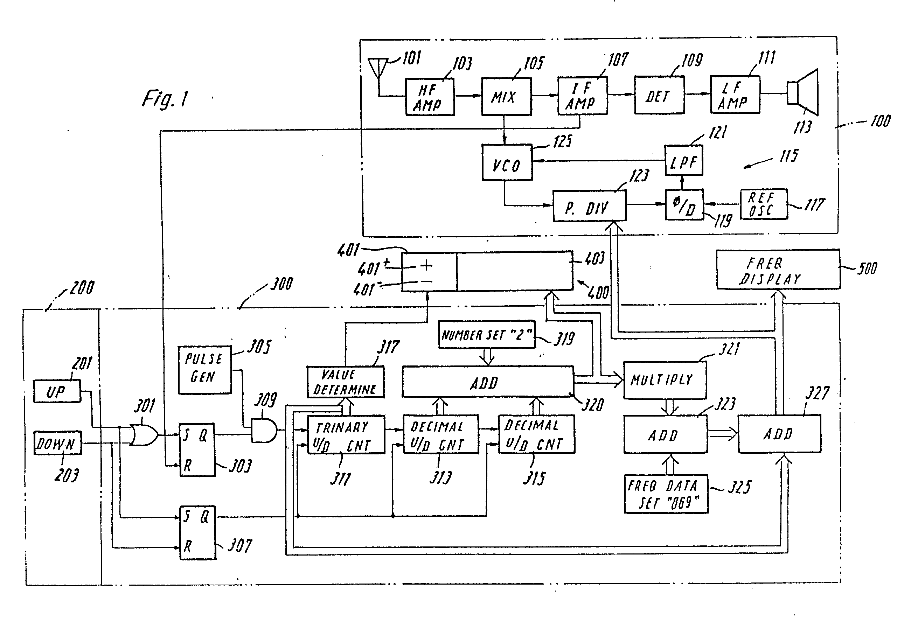

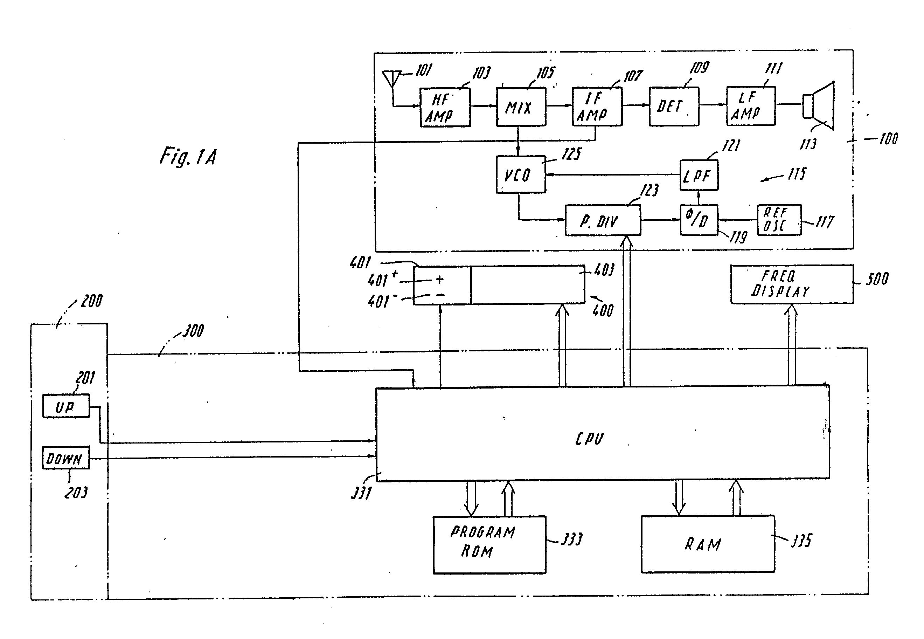

Fig. 1 is a block diagram showing one embodiment of the present invention. A high frequency signal received by an antenna 101 is amplified by a high frequency amplifier 103 and the output therefrom is applied to a mixer 105. The mixer 105 is connected to receive as a local oscillation signal the oscillation output obtained from a voltage controlled oscillator 125 included in a phase locked loop 115. Accordingly, in the mixer 105 the high frequency signal thus amplified is mixed with the local oscillation signal obtained from the voltage controlled oscillator to be converted into an intermediate frequency signal, which is then applied to an intermediate frequency amplifier 107. The output of the intermediate frequency amplifier 107 is detected by a detector 109 and a low frequency signal or an audio signal thus obtained is applied to a low frequency amplifier 111. The low frequency amplifier drives a speaker 113 in association with the audio signal applied thereto. An FM band radio receiver 100 is thus structured.

The phase locked loop 115 comprises a reference oscillator 117. The reference oscillator 117 comprises a crystal, for example, the output of which is applied to a phase comparator 119. The phase comparator 119 is further connected to receive at the other input thereto the output of a programmable frequency divider 123, connected to receive the oscillator output of the voltage controlled oscillator 125. Accordingly, the phase comparator 119 serves to compare the phases of the signal obtained from the reference oscillator 117 and the signal obtained from the programmable frequency divider 123, thereby to provide a voltage signal associated with the phase difference therebetween, which is applied through a low pass filter 121 to the above described voltage controlled oscillator 125 as a control voltage. The data to be set in the programmable frequency divider 123 as a frequency division ratio is obtained from an addition circuit 327 included in a control circuit 300.

The control circuit 303 is connected to an upward switch 201 for commanding an upward automatic scanning and a downward switch 203 for commanding a downward automatic scanning included in a station selecting switch group 200 and is also connected to a channel display 400 and a receiving frequency display 500. The upward switch 201 and the downward switch 203 are structured to provide a signal of the high level or the logic one upon depression or operation thereof. The signal obtained from the upward switch 201 and the signal obtained from the downward switch 203 are applied to an OR gate 301 included in the control circuit 300 and is also applied to the set input and the reset input of a flip-flop 307, respectively. The output of the OR gate 301 is applied to the set input of a flip-flop 303. The reset input of the flip-flop 303 is connected to receive a signal representative of a tuning state by the above described radio receiver 100 obtained from the intermediate frequency amplifier 107 thereof. Accordingly, the flip-flop 303 is set responsive to operation of either the upward switch 201 or the downward switch 203 and is reset responsive to the signal representative of a tuning state by the radio receiver 100. The non-inverted output of the flip-flop 303 is applied to one input of an AND gate 309. The other input of the AND gate 309 is connected to receive a pulse obtained from a pulse generator 305. The pulse generator 305 may comprise an astable multivibrator for example, the output pulse of which is applied to the AND gate 309. The pulse obtained through the AND gate 309 from the pulse generator 305 serves as a station selecting pulse and is applied to a count input of a trinary counter 311. A count up or carry signal of the trinary counter 311 is applied to a count input of a decimal counter 313 and the count up or carry output of the decimal counter 313 is applied to a decimal counter 315 as a count input. These counters 311, 313 and 315 are each structured as an up/down counter and, in order to command each of these in an up-count mode or a down-count mode, the non-inverted output of the above described flip-flop 307 is applied to these counters 311, 312 and 315. More specifically, if and when the non-inverted output of the flip-flop 307 is the high level or the logic one, these counters 311, 313 and 315 operate in an up count mode and, if and when the non-inverted output of the flip-flop 307 is the low level or the logic zero, these counters 311, 313 and 315 operate in a down count mode.

The count value in the trinary counter 311 is applied to a numerical value determining circuit 317 in a bit parallel fashion. The numerical value determining circuit 317 determines the channel index responsive to the count value in the trinary counter 311. More specifically, if and when the numerical value in the trinary counter 311 is "0", the numerical value determining circuit 317 determines the numerical value as the channel index "—" and if and when the count value in the trinary counter 311 is "2" the numerical value determining circuit 317 determines the numerical value as the channel index "+". The determined output of the numerical value determining circuit 317 is applied to the channel index display 401 of the channel display 400, with the result that either of the indexes 401⁺ and 401⁻ of the channel index display portion 401 is driven to display the same or neither is driven.

The count values in the two decimal counters 313 and 315 are applied to an addition circuit 320 in a bit parallel fashion, respectively. The other input of the addition circuit 320 is connected to receive in a bit parallel fashion a code signal representative of a specified numerical value "2" as preset in a specified number setting circuit 319. The numerical value "2" set in the specified number setting circuit 319 is selected to render the Channel Nos. 0⁻, 0, 0⁺, 1⁻, 1, and 1⁺ at the lower extremity of the FM band unreceivable. The output of the addition circuit 320, i.e. the sum obtained by addition of the numerical values in the decimal counters 313 and 315 and the above described specified numerical value "2" is applied to a channel number display portion 403 of the channel display 400 as channel number data. Simultaneously, the channel number data obtained from the addition circuit 320 is applied to a multiplication circuit 321. The multiplication circuit 321 serves to multiply the channel number data thus obtained by the number "3". The channel number data is multiplied by 3 by the multiplication circuit 321, because the broadcasting frequencies of three independent channels have been allotted to each one channel number as described previously. The result or the product of the above described multiplication by the multiplication circuit 321 is applied to an addition circuit 323. The other input of the addition circuit 323 is connected to receive the data "869" associated with the lowest frequency obtained from a lowest frequency data setting circuit 325. The lowest frequency data is determined in consideration of the fact that the Channel No. 0⁻ of the FM band is 86.9 MHz. The result or sum of the addition of the addition circuit 323 is further applied to an addition circuit 327. The other input of the addition circuit 327 is connected to receive the count value in the above described trinary counter 311. The addition circuit 327 serves to make addition of these two inputs to provide as the output therefrom data associated with receiving frequency. The receiving frequency associated data obtained from the addition circuit 327 is set, as a frequency division ratio, in the programmable frequency divider 123 included in the above described phase locked loop 115 and is also applied to a frequency display 500 to display the receiving frequency. Meanwhile, in case of a lower side superheterodyne receiver, the local oscillation frequency is lower than the receiving frequency by a frequency difference commensurate with the intermediate frequency and therefore the programmable frequency divider performs in actually a frequency dividing operation at the value of the receiving frequency associated data minus the intermediate frequency associated data.

Now the operation of the Fig. 1 embodiment will be described. In an initial condition, the count values in the trinary counter 311 and the decimal counters 313 and 315 included in the control circuit 300 are all "0". At that time one input of the addition circuit 320 has been supplied with the numerical value "2" from the specified number setting circuit 319. Accordingly, the output of the addition circuit 320 is "2" in the initial condition. Accordingly, the numerical value "2" is obtained as channel number data and the numerical value "2" is displayed in a digital manner by the channel number display portion 403 of the channel display 400 in the initial condition. Since at that time the count value in the trinary counter 311 is "0", the numerical value determining circuit 317 determines the numerical value as nil and accordingly the channel index 401⁻ included in the index display portion 401 of the channel display 400 is driven to display the index. Thus, in the initial condition channel No. 2⁻ is displayed by the channel display 400.

On the other hand, the channel number data obtained from the addition circuit 320 is multiplied by 3. Accordingly, one input of the addition circuit 323 is supplied with the numerical value "6". Therefore, the result or the sum of the addition obtained from the addition circuit 323 becomes "875". Since in the initial condition the count value in the trinary counter 311 is "0", the result or the sum of the addition obtained from the addition circuit 327 is also obtained as "875". Accordingly, the programmable frequency divider 123 included in the phase locked loop 115 is loaded with a frequency division ratio of the above described data "875". At the same time, the frequency display 500 makes a digital display of 87.5 MHz. Thus, it is indicated that the frequency 87.5 MHz is Channel No. 2⁻.

Now consider a case where the upward switch 201 is operated in the above described initial condition. Upon manual operation of the upward switch 201, the flip-flop 307 is set responsive to the signal obtained from the upward switch 201 and the flip-flop 303 is set responsive to the signal obtained from the upward switch 201 through the OR gate 301. As the flip-flop 307 is set, the non-inverted output thereof becomes the high level or the logic one, whereby the trinary counter 311 and the decimal counters 313 and 315 are all rendered in an up count mode. Since at the same time the non-inverted output of the flip-flop 303 becomes the high level or the logic one, the pulse obtained from the pulse generator 305 is applied through the AND gate 309 to the count input of the trinary counter 311 as a station selecting pulse. When the first station selecting pulse is received, the trinary counter 311 counts "1". However, since there occurs no change in the decimal counters 313 and 315, the channel number data obtained from the addition circuit 320 remains "2". Accordingly, the channel number display portion 403 of the channel display 400 still displays the channel number "2". However, since the trinary counter 311 counts the first pulse and the count value therein becomes "1", the numerical value determining circuit 317 determines the numerical value to the effect, whereby display of the index 401⁻ of the index display portion 401 of the channel display 400 is disabled or extinguished. Therefore, upon receipt of the above described first station selecting pulse, the channel display 400 will display Channel No. 2 or 2⁰. On the other hand, since the count value in the trinary counter 311 becomes "1", the output of the addition circuit 327 as the frequency associated data becomes "876". Accordingly, the frequency division ratio of the programmable frequency divider 123 included in the phase locked loop 115 is set on the basis of the above described frequency associated data "876", while the frequency of 87.6 MHz is displayed by the receiving frequency display 500. Thus, upon receipt of the first station selecting pulse, a display is made of Channel No. 2 and the frequency of 87.6 MHz.

Thereafter the second pulse is applied from the pulse generator 305 through the AND gate 309 to the trinary counter 311 as a station selecting pulse. Then the trinary counter 311 counts the same and the count value in the trinary counter 313 becomes "2". However, the count values in the decimal counters 311 and 315 still remain "0", and accordingly the channel number display portion 403 included in the channel display 400 still displays "2" as the channel number. Since the count value in the trinary counter 311 becomes "2", the numerical value determining circuit 317 determines the same and the plus index 401⁺ included in the channel index display portion 401 of the channel display 400 is driven or enabled. On the other hand, the output of the addition circuit 327 becomes "877", whereby the frequency of 87.7 MHz is displayed by the frequency display 500, while the numerical value "877" is set in the programmable frequency divider 123 as a frequency division ratio. Thus, upon receipt of the second station selecting pulse, indication is made of Channel No. 2⁺ and the broadcasting frequency of 87.7 MHz.

Then the third station selecting pulse is applied from the station selecting pulse generator 305 to the trinary counter 311, when the count value in the counter 311 again becomes "0", while the carry pulse is applied to the decimal counter 313. Accordingly, the count value in the decimal counter 313 becomes "1". Therefore, the output of the addition circuit 320 becomes "3" and the numerical value "3" is obtained as the channel number data. Therefore, channel number 3⁻ is displayed by the channel display 400. On the other hand, since the channel number data has become "3", the output of the multiplication circuit 321 becomes "9" and accordingly the output of the addition circuit 323 becomes "878". On the other hand, since the count value in the trinary counter 311 is "0", the output of the addition circuit 327 becomes "878". Accordingly, the frequency of 87.8 MHz is displayed by the frequency display 500 and the corresponding data is set in the programmable frequency divider 123. Thus, upon each application of the pulse from the pulse generator 305 as a station selecting pulse, the channel number is sequentially renewed for every 300 kHz and the channel index is sequentially renewed for every 100 kHz in the display, while the frequency division ratio in the programmable frequency divider 123 of the phase locked loop 115 and thus the oscillation frequency of the voltage controlled oscillator 125 is sequentially changed. At the same time, the frequency display by the receiving frequency display 500 is also renewed for every 100 kHz. Thereafter, in a similar manner, each time a station selecting pulse is obtained from the pulse generator 305, the data displayed by the frequency display 500 and the channel display 400 is renewed.

Now description is made of a case where the downward switch 203 is temporarily operated in the initial condition, i.e. when the count values in the trinary counter 311 and the decimal counters 313 and 315 are "0". In such a case, as in case of operation of the upward switch 201, the flip-flop 303 is set. On the other hand, the flip-flop 307 is reset, so that the non-inverted output becomes the low level or the logic zero. Accordingly, the trinary counter 311 and the decimal counters 313 and 315 are brought to the down count mode. The pulse obtained from the pulse generator 305 is applied through the AND gate 309 to the trinary counter 311. However, since the count values in the counters 311, 313 and 315 are all "0", no further down count can occur. Accordingly, even if the station selecting pulse obtained from the pulse generator 305 is applied, the count values in the counters remain "0", with the result that the channel number data obtained from the addition circuit 317 remains "2". This means that Channel Nos. 0 and 1 of the FM band cannot be received by the radio receiver 100 in discussion. In case where such Channel Nos. 0 and 1 are allotted to police wireless communication, it is desired such channels are unreceivable. In this context, it would be appreciated that if and when a radio receiver is structured to make addition of a predetermined specified number such as "2" and a channel number associated numerical value in setting the channel number data, as in case of the embodiment shown, it is simply possible to render unreceivable the broadcasting frequencies of the channels at the extremity of a frequency band reception of which channels is not desired. Meanwhile, if and when a radio receiver is structured as shown in the embodiment such that the local oscillator of the receiver 100 is implemented by a frequency synthesizer and the output of the addition circuit 327 is utilized as a frequency division ratio to be set in the programmable frequency divider 123 and generation of the station selecting pulse is discontinued responsive to a tuning state representing signal obtained from the intermediate frequency amplifier 107, then an automatic tuning operation can be readily performed.

In case where a voltage controlled oscillator is utilized as a local oscillator of the radio receiver 100, the receiver may be structured such that the frequency data obtained from the addition circuit 327 is at once converted to an analog voltage, which is applied to the voltage controlled oscillator. Furthermore, although the Fig. 1 embodiment was structured such that depression of either the upward switch 201 or the downward switch 203 causes continual supply of the station selecting pulse from the AND gate 309, alternatively, the embodiment may be structured such that only one station selecting pulse is generated upon each depression of either the upward switch 201 or the downward switch 203, so that the flip-flop 305, the pulse generator 305 and the AND gate 309 may be omitted. However, in such a modification, it might be required to provide a wave shaping circuit to ensure that one station selecting pulse is surely generated upon each depression of the upward switch 201 or the downward switch 203.

Although in the Fig. 1 embodiment the control circuit 300 was described as implemented by discrete hardware schemes, it is clear that such control circuit can be implemented by using a microprocessor or a microcomputer now commercially available.

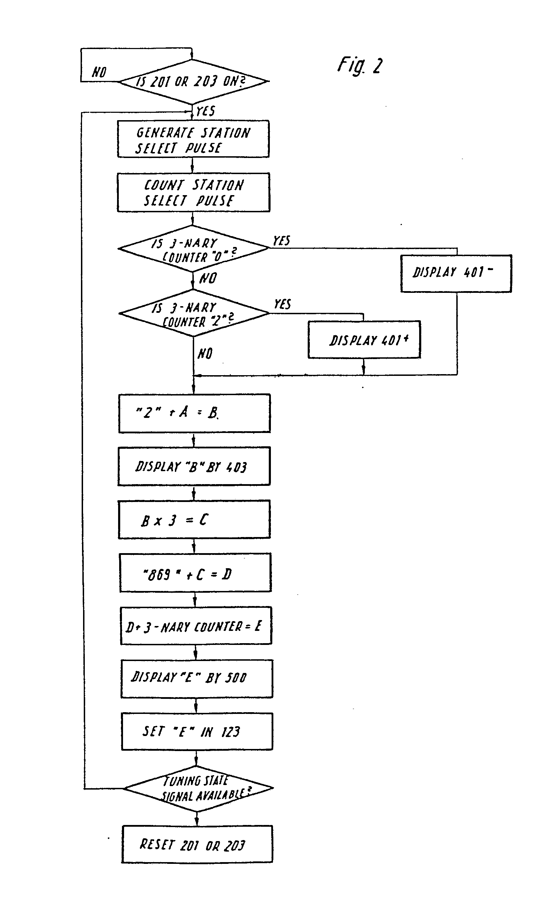

Fig. 1A is a block diagram showing another embodiment of the present invention wherein the control circuit 300 is implemented by a microcomputer. The microcomputer shown comprises a processing unit 331, a read only memory 333 for storing an operation program of the processing unit 331, and a random access memory 335 structured such that data obtained from the processing unit is written in addresses thereof and the data is read out from the addresses responsive to addressing by the processing unit 331. The read only memory 333 is in advance loaded with the operation program as shown in Fig. 2 to be described subsequently, so that the instructions are obtained from the addresses thereof and are applied to the processing unit 331 responsive to addressing by the processing unit 331. Those counters similar to the counters 311, 313 and 315 shown in Fig. 1 may be implemented by predetermined address portions in the random access memory 335, for example.

Fig. 2 is a flow diagram showing the operation program in case where the control circuit 300 shown in Fig. 1 is implemented by a microprocessor. First of all the control circuit 300 is responsive to depression of the upward switch 201 or the downward switch 203 to step up a counter which may be structured as shown in Fig. 1 including a trinary counter and decimal counters formed in predetermined regions of a random access memory 335 provided operatively coupled to the control circuit 300. The channel index is determined based on the count value in the trinary counter. To that end, first it is determined whether or not the channel index is "−" and, if so, the index 401⁻ included in the channel index display portion 401 of the channel display 400 as shown in Fig. 1 is enabled. If and when the channel index is not "−" then it is further determined whether or not the channel index is "+". If and when the channel index is "+" then the index 401⁺ of the channel index display portion 401 is enabled. After the channel index is enabled, or if and when the channel index is neither "−" nor "+", then addition is made of the count value A in the decimal counter included in the above described counter and the specified number "2", thereby to evaluate the channel number data B. The channel number display portion 403 included in the channel display 400 is enabled based on the channel number data B thus evaluated. Then the data C is obtained by multiplying the channel number data B by 3. The data C is further subjected to addition to the minimum frequency data "869". The result or the sum D of the addition of the data C and the minimum frequency data "869" is further added to the count value in the trinary counter. The sum E of the data D and the count value in the trinary counter is used as data associated with the receiving frequency and the receiving frequency display 500 shown in Fig. 1 is enabled responsive thereto, for example. The above described receiving frequency associated data E is also applied to the programmable frequency divider 123 included in the phase locked loop. Accordingly the voltage controlled oscillator of the receiver 100 is controlled such that the same receives the broadcasting frequency corresponding to the above described receiving frequency data E and thus the channel number data B. Thereafter the control circuit 300 determines whether or not a tuning state representing signal shown in Fig. 1 is obtained. If the above described tuning state representing signal is obtained, the upward switch 201 or the downward switch 203 is reset. If the tuning state representing signal is not obtained, the counters continue to effect a counting operation. Thus, the present invention can also be achieved by employing a microprocessor or a microcomputer as the above described control circuit.

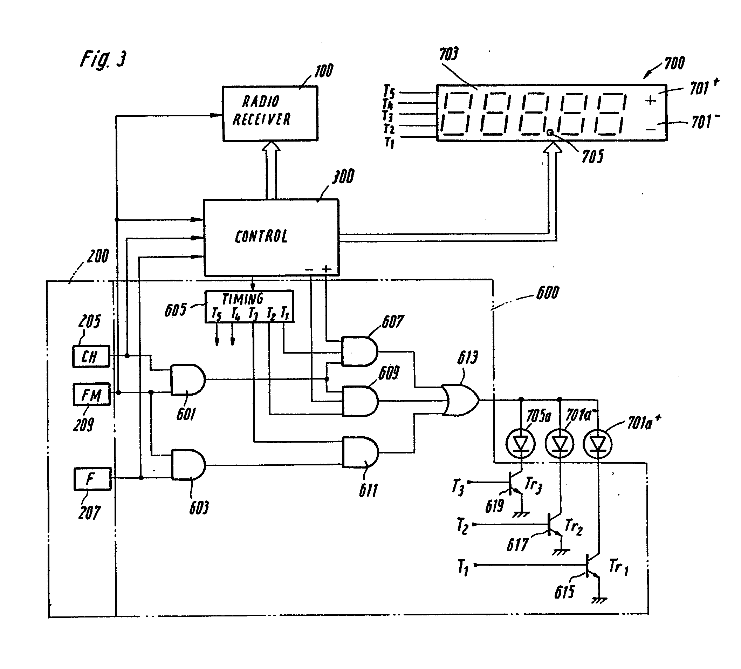

Fig. 3 is a schematic diagram showing another embodiment of the present invention. The Fig. 3 embodiment is different from the Fig. 1 embodiment in that the Fig. 1 embodiment comprises separately the channel display 400 and the receiving frequency display 500 whereas the Fig. 3 embodiment comprises a common display 700 which is controlled to selectively display the channel number and the receiving frequency. Since the radio receiver 100 and the control portion 300 of the Fig. 3 embodiment are substantially the same as those shown in the embodiments of Figs. 1, 1A and 2, a detailed description thereof is omitted. The common display 700 comprises a numerical display portion 703 including a five-digit display portion, indexes $701^+$ and $702^-$ for displaying channel indexes, and a decimal point display portion 705 for use in displaying a receiving frequency in the numerical value display portion 703. The indexes $701^+$ and $701^-$ and the decimal point displaying portion 705 are adapted to make display by light emission from light emitting diodes $701^+$a, $701^-$a and 705a.

In order to switchably display a receiving frequency or a channel by the common display 700, a channel display switch 205 and a frequency display switch 207 are provided in the station selecting switch group 200 as manual operable switches in addition to the upward switch 201 and the downward switch 203 shown in Fig. 1. An FM band selection switch 209 is necessary in the station selecting switch group 200 in case where a radio receiver 100 is structured to receive not only an FM band but also an LW band, MW band and/or SW band. These switches 205, 207 and 209 are structured to provide a signal of the high level or the logic one responsive to operation thereof, which signal is applied to the control portion 300. The signal obtained from the FM band selection switch 209 is applied to the radio receiver 100 thereby to switch the receiver 100 to the FM band.

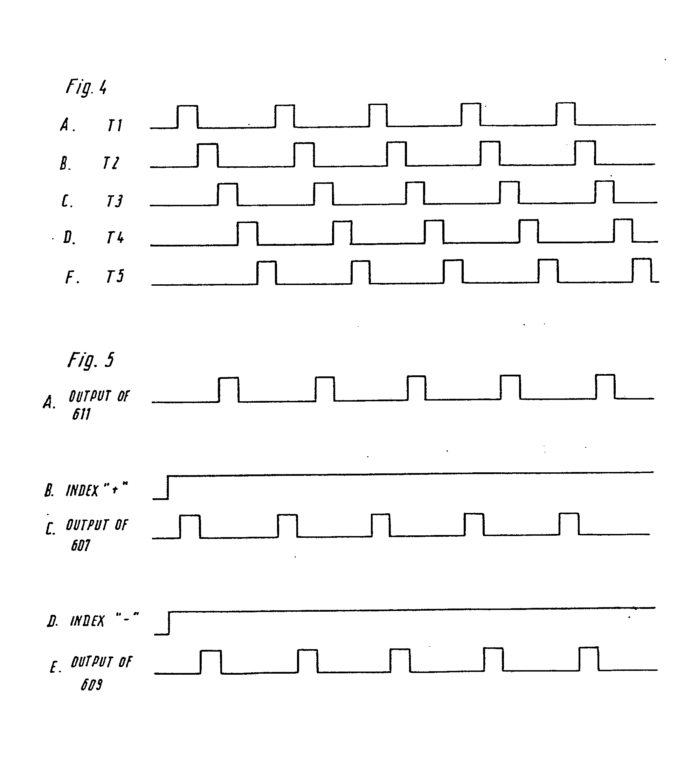

The embodiment shown further comprises a display control circuit 600 for enabling the indexes $701^+$ and $701^-$ of the common display 700 and the decimal point display portion 705. The display control circuit 600 comprises a timing signal generator 605. The timing signal generator 605 is adapted to sequentially and cyclically generate timing signals T1 to T5 as shown in Fig. 4, for example. The timing signals T1 to T5 are applied to the common display 700 as digit driving signals. The timing signals T1, T2 and T3 obtained from the timing signal generator 605 are applied to AND gates 607, 609 and 611, respectively. The signal obtained from the channel display switch 205 is applied to an AND gate 601 and the signal obtained from the frequency display switch 207 is applied to an AND gate 603. The AND gate 601 and 603 are also connected to commonly receive at the other input of each of them the signal obtained from the FM band selecting signal 209. The output of the AND gate 601 is applied to one input of each of the above described AND gates 607 and 609. The output of the AND gate 603 is applied to the other input of the AND gate 611. The AND gate 607 is structured as a three-input gate and is further connected to receive at the remaining input the signal representing the channel index being "+" obtained from the control circuit 300 (the numerical value determining circuit 317 in case of the Fig. 1 structure). Similarly, the AND gate 609 is also structured as a three-input gate and is connected to receive at the remaining input the signal representing the channel index being "−". The outputs of these AND gates 607, 609 and 611 are applied to an OR gate 613. The output of the OR gate 613 is commonly connected to the anodes of the light emitting diodes $701^+$a, $701^-$a and 705a of the common display 700. The cathode of the light emitting diode $701^+$a is connected through a transistor 615 to the ground, the cathode of the light emitting diode $701^-$a is connected through a transistor 617 to the ground, and the cathode of the light emitting diode 705a is connected through a transistor 619 to the ground. The bases of these transistors 615, 617 and 619 are connected to receive the timing signals T1, T2 and T3 obtained from the timing signal generator 605, respectively, as the switching control signals thereof.

Now that the structural features of the embodiment shown were described in the foregoing, an operation of the embodiment will be described with reference to the waveforms shown in Fig. 5. At the outset, the FM band selecting signal 209 is operated in order to receive a broadcasting signal in the FM band by means of the radio receiver 100 and then the upward switch 201 or the downward switch 203 as shown in Fig. 1 is operated. Then, as described previously, the channel number data and the receiving frequency associated data are obtained from the control circuit 300 and applied to the common display 700. It is needless to say that the common display 700 additionally comprises a well known circuit such as a segment decoder for selectively driving the associated segments in the numerical value display portion 703 responsive to the above described data. At the same time, the receiving frequency associated data obtained from the control circuit 300 is applied to the programmable frequency divider 123 (Fig. 1) included in the phase locked loop 115 of the radio receiver 100.

Now consider a case where the frequency display switch 207 is operated for the purpose of displaying the receiving frequency by the common display 700. Then the output of the AND gate 603 becomes the high level or the logic one and the output of the AND gate 611 becomes the high level or the logic one in synchronism with the timing signal T3 obtained from the timing signal generator 605. At the same time the transistor 619 is rendered conductive responsive to the timing signal T3 and accordingly the light emitting diode 705a is energized to be lighted in synchronism with the timing signal T3. Accordingly, the receiving frequency associated data obtained from the control circuit 300 is displayed in a digital manner by means of the numerical value display portion 703 of the common display 700. At that time the decimal point displaying portion 705 has been displayed by the light emitting diode 705a, while the receiving frequency in the FM band is displayed by the numerical value display portion 703 in terms of the unit of MHz. See Fig. 5A.

Now consider a case where the channel display switch 205 is operated to display the channel number. Then the output of the AND gate 601 becomes the high level or the logic one. Assuming that the signal representing the channel index being "+" has been obtained from the control circuit 300 as shown in Fig. 5B, then the output of the AND gate 607 provides the high level or the logic one in synchronism with the timing signal T1 as shown in Fig. 5C. Since the timing signal T1 renders the transistor 615 conductive, the light emitting diode 701+a is energized to be lighted in synchronism with the timing signal T1. Accordingly, the index 701+ of the common display 700 is displayed. At that time the channel number data has been obtained from the control circuit 300. Since the light emitting diode 705a is not energized and thus is not lighted when the channel number data is to be displayed, the decimal point display portion 705 is not displayed.

Assuming that the signal representing the channel index being "−" has been obtained from the control circuit 300 as shown in Fig. 5D when the channel display switch 205 is operated, the index 701− of the common display 700 is energized to be displayed as shown in Fig. 5E in synchronism with the timing signal T2 obtained from the timing signal generator 605.

If and when it is desired that in the Fig. 3 embodiment the frequency of the SW band is also displayed, a switch for selecting the SW band may be provided, while a decimal point display portion may be provided at a digit position one digit less significant than that of the decimal point display portion 705 in the common display 700, so that the above described additional decimal point display portion may be selectively enabled on the occasion of display of the frequency of the SW band.

Thus, according to the Fig. 3 embodiment, in making display of a receiving frequency, the channel and the receiving frequency can be selectively displayed using a single common display. Furthermore, the Fig. 3 embodiment may be implemented in a simple structure, since the same was structured such that the decimal point display portion on the occasion of display of a receiving frequency and the indexes for displaying channel indexes are driven in a time sharing manner.

### Claims

1. A superheterodyne receiver to be tuned by selecting a desired tuning channel identified by a channel number, comprising

a manual channel selection input (200) connected to channel number processing means (300) for forming channel number data representing the number of a selected channel;

channel number display means (400) responsive to said channel number data for displaying the selected channel number;

and control means (123, 119) responsive to data converted from said channel number data for controlling the frequency of a local oscillator (125) included in the tuning circuit of the receiver;

said channel number processing means (311 to 320) comprising fixed number presetting means (319) for presetting a fixed number and operation means (320) for forming said channel number data by mathematical operation from said preset fixed number and a numerical value set associated with said channel number by numerical value setting means (200, 301 to 315)

characterized in that for use in an environment wherein in a given frequency band a series of channel numbers is allotted such that one channel number stands for a plurality (m) of independent channels grouped under said one channel number the receiver further comprises

frequency display means (500) responsive to frequency data converted from said channel number data by frequency data converting means (321 to 327) which include

multiplication means (321) for multiplying said channel number data by a factor commensurate with said plurality (m),

first addition means (323) for adding data associated with the frequency of a channel at one extremity of said frequency band to the product obtained by said multiplication means (321), and

second addition means (327) for adding to the sum of said first addition means (323) the count value of counting means (311) included in said channel number processing means,

said counting means (311) being provided for counting the number of channel number setting pulses supplied in response to the manual operation of the manual channel selection input (200).

2. A superheterodyne receiver in accordance with claim 1, characterized in that said channel number display means and said frequency display means are structured by a common display (700), and said superheterodyne receiver further comprises display switching means (205, 207) for selectively providing to said common display as display data said data concerning the channel number or said data concerning the receiving frequency.

3. A superheterodyne receiver in accordance with claim 2, characterized in that said common display comprises a decimal point display portion for displaying said data concerning the receiving frequency and a channel index display portion ($701^+$, $701^-$) for making display for specifying one of said plurality (m) of channels grouped in said one channel number, and said superheterodyne receiver further comprises

timing signal generating means (605) for generating timing signals and,

enabling means (607 to 613, 615, 617) responsive to said timing signals for enabling said decimal point display portion and said channel index display portion at different timing.

4. A superheterodyne receiver in accordance with claim 3, characterized in that said superheterodyne receiver further comprises

common connecting means (613) for connecting said decimal point display portion and said channel index display portion to a common signal line, and

synchronizing means (607 to 619) for controlling said enabling means for synchronizing enabling of said decimal point display portion and enabling of said channel index display portion with said different timing signals, respectively.

5. A superheterodyne receiver in accordance with claim 4, characterized in that said enabling means comprises selecting signal generating means (601, 603) for generating a selecting signal for selecting said decimal point display portion and a selecting signal for selecting said channel index display portion and

said synchronizing means comprises

signal converting means (607 to 613) for converting said selecting signal for selecting said decimal point display portion and said selecting signal for selecting said channel index portion into driving signals synchronized with said different timing signals, respectively, and

display control means (613, 615 to 619) responsive to said driving signals of said signal converting means for controlling said decimal point display portion and said channel index display portion.

**Patentansprüche**

1. Überlagerungsempfänger, der abgestimmt wird durch Auswahl eines gewünschten Abstimmkanals, der durch eine Kanalnummer identifiziert ist, mit einer manuellen Kanalwahleingabe (200), die mit einer Kanalnummerverarbeitungsvorrichtung (300) verbunden ist, um Kanalnummerndaten zu bilden, die die Nummer des ausgewählten Kanals repräsentieren;

einer Kanalnummernanzeige (400), die in Abhängigkeit von den Kanalnummerndaten die ausgewählte Kanalnummer anzeigt; und

einer Steuervorrichtung (123, 119), die in Abhängigkeit von aus den Kanalnummerndaten entwickelten Daten die Frequenz des im Abstimmkreis des Empfängers enthaltenen Überlagerungsoszillators (125) steuert;

wobei die Kanalnummernverarbeitungsvorrichtung (311—320) eine Fixnummer-Setzvorrichtung (319) zum Setzen einer festen Nummer und ein Rechenwerk (320) aufweist zum Erzeugen der Kanalnummerndaten durch eine mathematische Verarbeitung aus der gesetzten Fixnummer und einem mit der Kanalnummer verknüpften, durch eine Setzvorrichtung (200, 301 bis 315) für einen numerischen Wert gesetzten numerischen Wert, dadurch gekennzeichnet, daß für die Benutzung in einer Umgebung, in welcher in einem vorgegebenen Frequenzband eine Reihe von Kanalnummern so zugeteilt ist, daß eine Kanalnummer für eine Vielzahl (m) von unabhängigen unter der einen Kanalnummer gruppierten Kanälen steht, der Empfänger ferner aufweist:

eine Frequenzanzeigevorrichtung (500), die abhängig ist von den Frequenzdaten, die aus den Kanalnummerndaten entwickelt werden durch eine Frequenzdaten-Konvertervorrichtung (321 bis 327), welche enthält:

ein Multiplizierwerk (321) zum Multiplizieren der Kanalnummerndaten mit einem Faktor, der der Vielzahl (m) entspricht,

ein erstes Addierwerk (323) zum Addieren von mit der Kanalfrequenz an einem Ende des Frequenzbandes verknüpften Daten zu dem Produkt aus dem Multiplizierwerk,

ein zweites Addierwerk (327) zum Addieren des Zählwertes einer Zählervorrichtung (311), welche in der Kanalnummernverarbeitungsvorrichtung enthalten ist, zur Zumme aus dem ersten Addierwerk (323);

wobei die Zählervorrichtung (311) vorgesehen ist zum Zählen der Anzahl von Kanalnummern-Setzimpulsen, die in Abhängigkeit von der Betätigung der manuellen Kanalwähleingabe (200) zugeführt werden.

2. Empfänger nach Anspruch 1, dadurch gekennzeichnet, daß die Kanalnummern-anzeige und die Frequenzanzeigevorrichtung durch eine gemeinsame Anzeige (700) gebildet werden, und daß der Überlagerungsempfänger ferner eine Anzeigeumschaltvorrichtung (205, 207) aufweist zum wahlweisen Zuführen der die Kanalnummer betreffenden Daten oder der die Empfangsfrequenz betreffenden Daten als Anzeigedaten an die gemeinsame Anzeige.

3. Empfänger nach Anspruch 2, dadurch gekennzeichnet, daß die gemeinsame Anzeige einen Dezimalpunktanzeigeteil zum Anzeigen der die Empfangsfrequenz betreffenden Daten und eine Kanalindexanzeige (701+, 701−) aufweist zum Anzeigen für die Spezifizierung eines der Kanäle aus der Vielzahl (m), die unter der einen Kanalnummer gruppiert sind, und daß der Überlagerungsempfänger ferner aufweist

einen Synchronsignal-Generator (605) zum Erzeugen von Synchronsignalen und

eine Aktivierungsvorrichtung (607 bis 613, 615, 617), die in Abhängigkeit vom Synchronisiersignal den Dezimalpunktanzeigeteil und den Kanalindexanzeigeteil zu verschiedenen Zeiten aktiviert.

4. Empfänger nach Anspruch 3, dadurch gekennzeichnet, daß der Überlangerungsempfänger ferner aufweist

eine gemeinsame Verbindungsvorrichtung (613) zum Verbinden des Dezimalpunktanzeigeteils und des Kanalindexanzeigeteils mit einer gemeinsamen Signalleitung, und

eine Synchronisiervorrichtung (607, 619) zum Steuern der Aktivierungsvorrichtung zum Synchronisieren der Aktivierung der Dezimalpunktanzeige bzw. der Kanalindexanzeige mit den unterschiedlichen Synchronisiersignalen.

5. Empfänger nach Anspruch 4, dadurch gekennzeichnet, daß die Aktivierungsvorrichtung einen Wahlsignalgenerator (601, 603) aufweist zum Erzeugen eines Wahlsignals zum Auswählen des Dezimalpunktanzeigeteils und eines Wahlsignals für das Auswählen des Kanalindexanzeigeteils, und

daß die Synchronisationsvorrichtung aufweist einen Signalkonverter (607, 613) um Umwandeln des Wahlsignals für die Dezimalpunktanzeige und des Wahlsignals für die Kanalindexanzeige in Treibersignale, die jeweils mit den verschiedenen Synchronisiersignalen synchronisiert sind, und

eine Anzeigesteuervorrichtung (613, 615 bis 619), die in Abhängigkeit vom Treibersignal des Signalkonverters den Dezimalpunktanzeigeteil und den Kanalindexanzeigeteil steuert.

## Revendications

1. Un récepteur superhétérodyne devant être accordé par sélection d'un canal d'accord désiré, identifiée par un numéro de canal, comprenant

une entré de sélection manuelle de canal (200) connectée à des moyens de traitement de numéro de canal (300) pour former des données de numéro de canal représentant le numéro d'un canal sélectionné;

des moyens d'affichage de numéro de canal (400) réagissant aux données de numéro de canal en affichant le numéro de canal sélectionné;

et des moyens de commande (123, 119) qui réagissent à des donnés converties à partir des données de numéro de canal en commandant la fréquence d'un oscillateur local (125) incorporé dans le circuit d'accord du récepteur;

les moyens de traitement de numéro de canal (311 à 320) comprenant des moyens de préréglage d'un nombre fixe (319) destinés à prérégler un nombre fixe, et des moyens de calcul (320) destinés à former les données de numéro de canal par une opération mathématique portant sur le nombre fixe préréglé et sur une valeur numérique associée au numéro de canal, qui est fixée par des moyens de fixation de valeur numérique (200, 301 à 315)

caractérisé en ce que, pour l'utilisation dans un environnement dans lequel, dans une bande de fréquence donnée, une série de numéros de canal sont affectés de façon qu'un numéro de canal s'applique à un certain nombre (m) de canaux indépendants groupés sous ce numéro de canal unique, le récepteur comprend en outre

des moyens d'affichage de fréquence (500) qui réagissant aux données de fréquence converties à partir des données de numéro de canal par des moyens de conversion de données de fréquence (321 à 327) qui comprennent

des moyens de multiplication (321) destinés à multiplier les donnés de numéro de canal par un facteur lié audit nombre (m),

des premiers moyens d'addition (323) destinés à additionner des données associées à la fréquence d'un canal à une extrémité de la bande de fréquence, au produit obtenu par les moyens de multiplication (321), et

des seconds moyens d'addition (327) destinés à additionner, à la somme fournie par les premiers moyens d'addition (323), la valeur de comptage de moyens de comptage (311) qui font partie des moyens de traitement de numéro de canal,

ces moyens de comptage (311) étant destinés à compter le nombre d'impulsions de fixation de numéro de canal qui sont appliqués sous l'effet de la manoeuvre manuelle de l'entrée de sélection manuelle de canal (200).

2. Un récepteur superhétérodyne selon la revendication 1, caractérisé en ce que les moyens d'affichage de numéro de canal et les moyens d'affichage de fréquence sont constitués par un afficheur commun (700), et le récepteur superhétérodyne comprend en outre des moyens de commutation d'affichage (205, 207) destinés à appliquer sélectivement à l'afficheur commun, en tant que données d'affichage, les données concernant le numéro de canal ou les données concernant la fréquence de réception.

3. Un récepteur superhétérodyne selon la revendication 2, caractérisé en ce que l'afficheur commun comprend une partie d'affichage de point décimal pour l'affichage des données concernant la fréquence de réception, et une partie d'affichage d'index de canal (701$^+$, 701$^-$) pour réaliser un affichage qui spécifie l'un des canaux du nombre (m) de canaux groupés sous le numéro de canal unique, et le récepteur superhétérodyne comprend en outre · des moyens de génération de signaux de rythme (605) destinés à produire des signaux de rythme, et des moyens de validation (607 à 613, 615, 617) qui réagissent aux signaux de rythme en validant à des moments différents la partie d'affichage de point décimal et la partie d'affichage d'index de canal.

4. Un récepteur supérhétérodyne selon la revendication 3, caractérisé en ce que ce récepteur supérhétérodyne comprend en outre des moyens de connexion commune (613) pour connecter à une ligne de signal commune la partie d'affichage de point décimal et la partie d'affichage d'index de canal, et des moyens de synchronisation (607 à 619) destinés à commander les moyens de validation pour synchroniser respectivement la validation de la partie d'affichage de point décimal et la validation de la partie d'affichage d'index de canal avec les différents signaux de rythme.

5. Un récepteur superhétérodyne selon la revendication 4, caractérisé en ce que les moyens de validation comprennent des moyens de génération de signaux de sélection (601, 603) destinés à produire un signal de sélection pour sélectionner la partie d'affichage de point décimal et un signal de sélection pour sélectionner la partie d'affichage d'index de canal, et les moyens de synchronisation comprennent: des moyens de conversion de signaux (607 à 613) destinés à convertir le signal de sélection pour la sélection de la partie d'affichage de point décimal et le signal de sélection pour la sélection de la partie d'index de canal en signaux d'attaque synchronisés respectivement avec les différents signaux de rythme, et des moyens de commande d'affichage (613, 615 à 619) qui réagissent aux signaux d'attaque des moyens de conversion de signaux en commandant la partie d'affichage de point décimal et la partie d'affichage d'index de canal.

Fig. 1

Fig. 1A

Fig. 2

```
        ┌─────────────┐
   NO   │ IS 201 OR 203 ON? │
        └─────────────┘
              │ YES
      ┌───────────────────┐
      │ GENERATE STATION  │
      │   SELECT PULSE    │
      └───────────────────┘
      ┌───────────────────┐
      │  COUNT STATION    │
      │   SELECT PULSE    │
      └───────────────────┘
        ┌─────────────┐   YES
        │ IS 3-NARY   │──────────┐
        │ COUNTER "0"?│          │
        └─────────────┘      ┌───────────────┐
              │ NO           │  DISPLAY 401⁻ │
        ┌─────────────┐   YES└───────────────┘
        │ IS 3-NARY   │──────────┐
        │ COUNTER "2"?│      ┌───────────────┐
        └─────────────┘      │  DISPLAY 401⁺ │
              │ NO           └───────────────┘
      ┌───────────────────┐
      │   "2" + A = B     │
      └───────────────────┘
      ┌───────────────────┐
      │ DISPLAY "B" BY 403│
      └───────────────────┘
      ┌───────────────────┐
      │     B x 3 = C     │
      └───────────────────┘
      ┌───────────────────┐
      │  "869" + C = D    │
      └───────────────────┘
      ┌─────────────────────────┐
      │ D + 3-NARY COUNTER = E  │
      └─────────────────────────┘
      ┌───────────────────┐
      │ DISPLAY "E" BY 500│
      └───────────────────┘
      ┌───────────────────┐
      │  SET "E" IN 123   │
      └───────────────────┘
        ┌─────────────┐
        │ TUNING STATE│
        │SIGNAL AVAILABLE?│
        └─────────────┘
      ┌───────────────────┐
      │ RESET 201 OR 203  │
      └───────────────────┘
```

3

Fig. 3

Fig. 4

A. T1

B. T2

C. T3

D. T4

F. T5

Fig. 5

A. OUTPUT OF
611

B. INDEX "+"

C. OUTPUT OF
607

D. INDEX "-"

E. OUTPUT OF
609